# EUROPEAN PATENT SPECIFICATION

(11) **EP 2 842 791 B1**
(45) Date of publication and mention of the grant of the patent: **25.08.2021**
(21) Application number: 14179244.0
(22) Date of filing: 31.07.2014
(51) Int. Cl.: B61C 17/00, H05K 7/00

(54) **Power converter**
Stromwandler
Convertisseur de puissance

(30) Priority: 28.08.2013 JP 2013176323
(43) Date of publication of application: 04.03.2015
(73) Proprietor: Hitachi, Ltd., Tokyo (JP)
(72) Inventor: Urushiwara, Noriyoshi, Chiyoda-ku, Tokyo 100-8280 (JP); Hishida, Akihiro, Chiyoda-ku, Tokyo 100-8280 (JP); Takagi, Takeo, Chiyoda-ku, Tokyo 100-8280 (JP)
(74) Representative: Mewburn Ellis LLP

(56) References cited:
- EP-A1- 2 555 409
- JP-A- H0 583 957
- JP-A- S60 200 703
- JP-A- 2005 160 248
- JP-A- 2010 259 300
- KR-A- 20030 004 149
- US-A- 6 021 060
- US-A- 6 160 696
- US-A1- 2012 227 616
- "Chapter 5 Protection Circuit Design 5-1 CONTENTS Page", , 31 May 2011 (2011-05-31), XP055153802, Retrieved from the Internet: URL:http://www.fujielectric.com/products/s emiconductor/technical/application/box/doc /REH984b/REH984b_05a.pdf [retrieved on 2014-11-18]
- ALLOCCO J M: "Laminated bus bars for power system interconnects", APPLIED POWER ELECTRONICS CONFERENCE AND EXPOSITION, 1997. APEC '97 CO NFERENCE PROCEEDINGS 1997., TWELFTH ANNUAL ATLANTA, GA, USA 23-27 FEB. 1997, NEW YORK, NY, USA,IEEE, US, vol. 2, 23 February 1997 (1997-02-23), pages 585-589, XP010215723, DOI: 10.1109/APEC.1997.575624 ISBN: 978-0-7803-3704-6

## Description

### BACKGROUND OF THE INVENTION

### 1. Field of the Invention

The present invention relates to a power converter, and specifically, is preferably applied to a power converter for rolling stock.

### 2. Description of the Related Art

A power converter provided in rolling stock power-converts DC power input from a railroad wire using a plurality of power switching elements and outputs the power to a motor for rolling stock. The power converter mainly includes the power switching elements, a cooling unit for cooling the power switching elements, and a filter capacitor for stabilization of the DC power input from the railroad wire.

Patent Document 1 (JP-A-5-83957) discloses a power converter that converts a three-phase AC voltage into a DC voltage, in which a unit for one phase is formed by series-connection of a positive arm having a configuration of parallel connection of a snubber circuit to a power switching element and a negative arm having the same configuration and three of the units for one phase are connected.

According to the power converter disclosed in Patent Document 1, connecting lines for connecting the units for three phases to one another may be made shorter, and high voltages applied to the power switching elements may be suppressed even when the capacities of the snubber circuits are smaller.

However, the snubber circuit in the power converter disclosed in Patent Document 1 includes a snubber resistor, a snubber diode, and a snubber capacitor, and is heavy and bulky particularly because of the snubber capacitor. Accordingly, in the configuration disclosed in Patent Document 1, it is impossible to reduce the weight of the power converter.

Further, the snubber circuits are heavy and bulky as described above, and necessary to be provided separately from the power switching elements within a casing that houses the power converter. When the snubber circuits are provided separately from the power switching element, the layout of the devices within the casing is restricted. Thus, it is impossible to downsize the power converter.

Furthermore, when the snubber circuits and the power switching elements are separately provided, the wiring between them is longer and, if the wiring is equal to or longer than a certain length, the inductance component of the wiring is not negligible. In this case, an inductance voltage is generated in the wiring part and it is impossible to properly protect the power switching elements.

EP A 2555409 proposes an electric vehicle control device. US 2012/0227616 proposes a drive control device. JP A 2010-259300 proposes a device for control of an electric rolling stock. KR A 1020030004149 proposes an inverter stack device having a multi-layered bus plate formed with one body to minimize stray inductance. US 6160696 proposes a modular bus bar and switch assembly for a traction inverter, the area between conductors of the bus bar and extension bus bars being minimized to reduce the inductance between IGBTs and capacitors. JP A 2005-160248 proposes a 3-level inverter circuit for simplified connection, smaller size and reduced thickness.

### SUMMARY OF THE INVENTION

The invention has been achieved in consideration of the above described points, and an object of the invention is to provide a power converter in which reduction in weight and size may be realized and improvement in reliability may be realized by properly protecting power switching elements.

In order to solve the problem, a power converter for rolling stock according to claim 1 is provided.

The length of the conductor bar between the overvoltage protection device and the filter capacitor has a negligible (i.e. substantially zero) inductance.

According to the invention, reduction in weight and size may be realized and improvement in reliability may be realized by properly protecting power switching elements.

### BRIEF DESCRIPTION OF THE DRAWINGS

Fig. 1 is an overall configuration diagram showing attachment positions of power converters.
Fig. 2 is a front configuration diagram of the power converter.
Fig. 3 is a perspective configuration diagram of the power converter.
Fig. 4 is a front configuration diagram of a main part of the power converter.
Fig. 5 is a circuit configuration diagram of the power converter.
Fig. 6 is a front configuration diagram of a power converter in related in-house state of the art.
Fig. 7 is a perspective configuration diagram of the power converter in related in-house state of the art.
Fig. 8 is a front configuration diagram of a main part of the power converter in related in-house state of the art.

### DESCRIPTION OF THE EMBODIMENTS

As below, one embodiment of the invention will be explained with reference to the drawings.

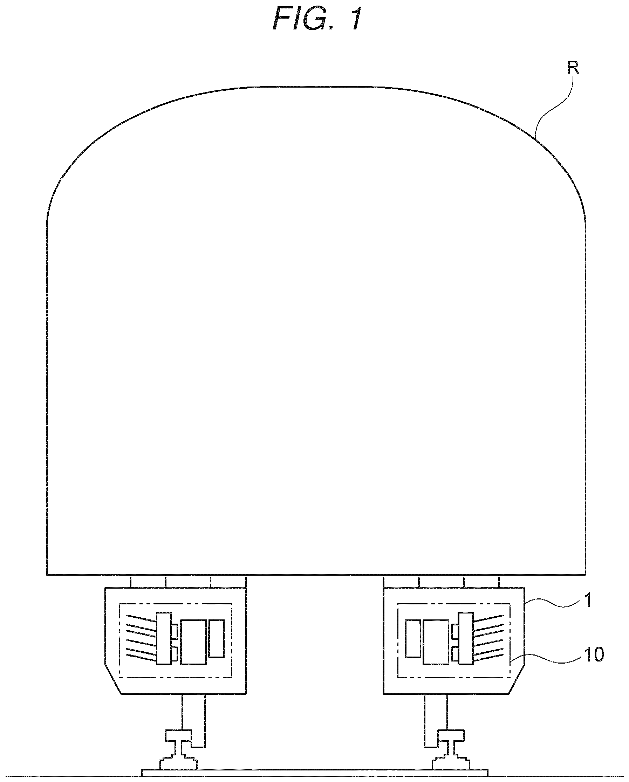

Fig. 1 shows attachment positions of power converters 10 in the embodiment. The power converter 10 is housed and installed inside of a casing 1 provided under the floor of rolling stock R.

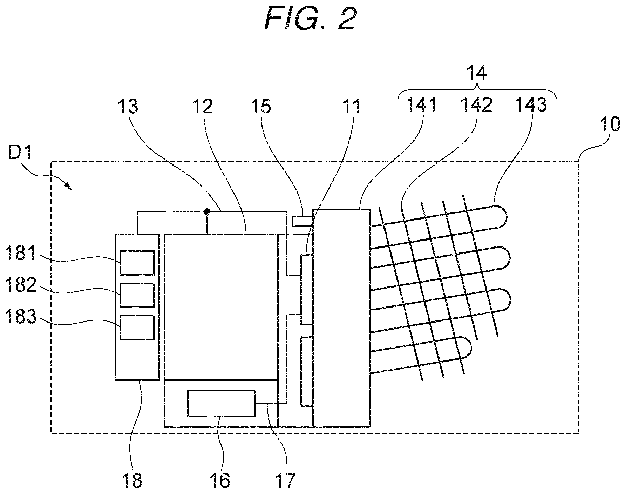

Fig. 2 shows a front configuration of the power converter 10. The power converter 10 includes power switching elements 11, a filter capacitor 12, a conductor bar 13, a cooling unit 14, input/output terminals 15, a gate control circuit 16, a gate wire 17, and an overvoltage protection device 18.

The power converter 10 is a device that generates DC from single-phase AC and a device that generates three-phase AC from DC. The former is called a converter and the latter is called an inverter.

The converter converts a single-phase AC voltage from an AC power source into a DC voltage and charges the filter capacitor 12 for DC voltage smoothing, and includes a two-phase leg.

The inverter converts the DC voltage charged in the filter capacitor 12 into an AC voltage by continuously changing a ratio of ON/OFF of the power switching elements 11, and includes a three-phase leg.

The power converter 10 generates three-phase AC via the converter and the inverter, and thereby, drives a motor provided in the rolling stock R. Note that any power conversion is performed through a group of semiconductors. Further, for conduction control, a controller separately provided outputs control signals and drives the power switching elements 11 via the gate control circuit 16 and the gate wire 17 mounted on the power converter 10.

The power switching element 11 is an IGBT (Insulated Gate Bipolar Transistor), for example. The IGBT has an advantage that the ON-resistance and the drive current are smaller and the switching speed is higher. On the other hand, the IGBT consumes high power at conduction and interruption and generates heat, and the cooling unit 14 is provided for heat dissipation in the embodiment.

The filter capacitor 12 is for smoothing the DC voltage as described above.

The conductor bar 13 is a connecting line having a flat plate shape for electrical connection to an external device, and also called a laminated bus bar. The laminated bus bar has a structure that suppresses an abnormal voltage (surge voltage) generated at high-speed switching in an electric circuit using the power switching elements 11 such as an IGBT.

Specifically, as a material for the conductor bar 13, copper having lower volume resistivity is used for suppression of heat generation of the conductor, and the conductor bar has a shape having larger conductor section area. The conductor bar 13 has a thin flat plate shape so that the wiring inductance is reduced.

The cooling unit 14 includes a cooling block 141, a cooling fin 142, and a heat pipe 143. The cooling block 141 absorbs heat generated from the power switching elements 11 and gasifies a cooling medium enclosed in the heat pipe 143 for cooling. The cooling fin 142 blows air to the gasified cooling medium and liquefies the cooling medium again by heat exchange. Note that the cooling unit 14 in the embodiment employs the heat pipe system, however, may employ a radiator system.

The input/output terminals 15 include DC terminals P and N for inputting DC and AC terminals U, V, and W for converting the DC input from the DC terminals P and N into three-phase AC at arbitrary frequencies and arbitrary voltages and outputting the AC.

The gate control circuit 16 is a circuit for generating and outputting gate signals. The gate wire 17 is a wire for outputting the gate signals generated and output from the gate control circuit 16 to the power switching elements 11.

The overvoltage protection device 18 includes a DC voltage detector 181, a power switching element 182, and a drive circuit 183. The overvoltage protection device 18 is a device for turning ON the power switching element 182 and releasing charge accumulated in the filter capacitor 12 when an overvoltage of the filter capacitor 12 is detected and when the control power source is turned OFF. The DC voltage detector 181 detects the overvoltage of the filter capacitor 12, the power switching element 182 is switched to ON when the charge accumulated in the filter capacitor 12 is released, and the drive circuit 183 switches ON/OFF by driving the power switching element 182.

Note that an overvoltage protection device in related in-house state of the art (described below) includes a snubber circuit in addition to the above described configuration. The snubber circuit is a circuit that commutates energy accumulated in the inductance component of the wiring to a snubber capacitor for suppressing a surge voltage generated when the power switching element 182 is turned OFF, and includes a snubber resistor, a snubber diode, and the snubber capacitor.

In the embodiment, the overvoltage protection device 18 formed by eliminating the snubber circuit from the overvoltage protection device in related in-house state of the art is employed for realization of reduction in weight and size.

Here, as described above, the snubber circuit is the circuit for suppressing the surge voltage and, when the snubber circuit is eliminated, suppression of the surge voltage is harder. However, in the embodiment, the overvoltage protection device 18 is provided closer to the filter capacitor 12 so that the length of the wiring (conductor bar 13) between the overvoltage protection device 18 and the filter capacitor 12 may be as short as possible. Thus, the inductance of the wiring is negligible and generation of the surge voltage may be suppressed.

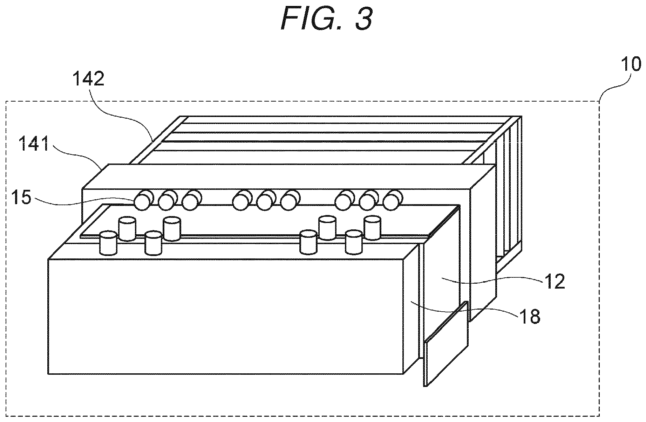

Fig. 3 shows a perspective configuration of the power converter 10. The perspective configuration shown in Fig. 3 is a perspective configuration as seen from a direction D1 shown in Fig. 2. In the power converter 10, the overvoltage protection device 18, the filter capacitor 12, the cooling block 141, and the cooling fin 142 are sequentially arranged from the front side to the depth side, and the input/output terminals 15 are provided in the cooling block 141. These are housed within the same casing 1 as the power converter 10.

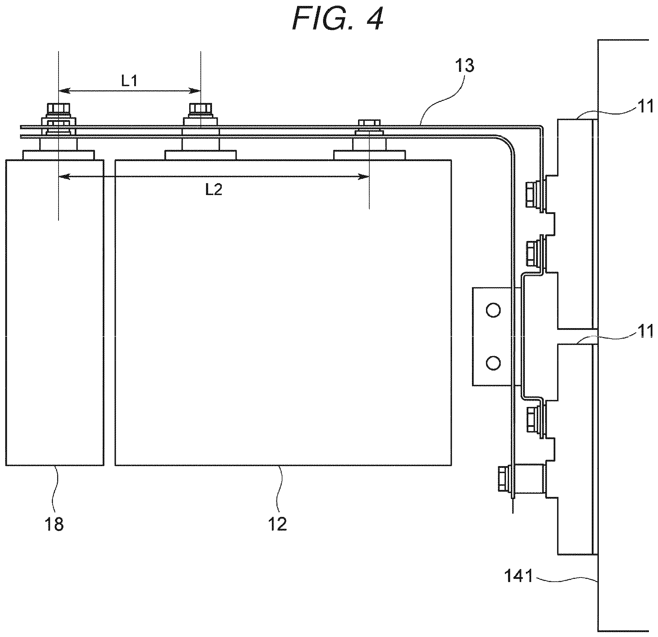

Fig. 4 shows a front configuration of a main part of the power converter 10. Here, of the power converter 10 shown in Fig. 2, particularly, the power switching elements 11, the filter capacitor 12, the conductor bar 13, the cooling block 141, and the overvoltage protection device 18 are shown.

The filter capacitor 12 and the overvoltage protection device 18 are arranged to be closer to each other so that terminals respectively provided may be in the same direction. The conductor bar 13 is provided to extend along the upper surfaces of the filter capacitor 12 and the overvoltage protection device 18 and to respectively connect the power switching elements 11, the filter capacitor 12, and the overvoltage protection device 18.

In the embodiment, the arrangement configuration in which physical distances L1 and L2 between the filter capacitor 12 and the overvoltage protection device 18 are as short as possible is employed, and, even when the snubber circuit is eliminated from the overvoltage protection device 18, generation of an induction voltage in the parts may be suppressed.

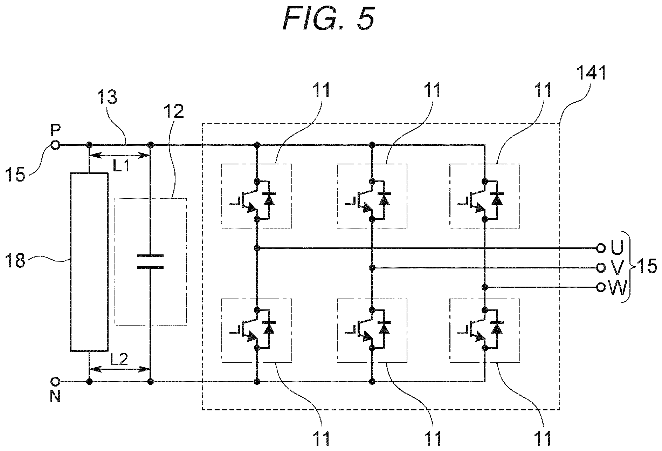

Fig. 5 shows a circuit configuration of the power converter 10. The feeding system for railroad includes an AC system and a DC system, and the motor includes an AC motor and a DC motor. Accordingly, depending on the combination of the feeding system and the motor, the power converter 10 may include a single inverter system, a single converter system, and a combination of them. In the embodiment, an inverter applied to the case of a combination of the DC feeding system and the AC motor will be explained as an example.

The main circuit of the power converter 10 in the embodiment includes the filter capacitor 12 connected between the DC terminals P and N of the input/output terminals 15, and a three-phase inverter. The three-phase inverter converts the input DC into three-phase AC at arbitrary frequencies and arbitrary voltages and outputs the three-phase AC to the AC terminals U, V, and W of the input/output terminals 15.

The three-phase inverter includes six of the power switching elements 11. The power switching element 11 for each phase includes an element and a free wheel diode parallel-connected to the element.

In the embodiment, the lengths L1 and L2 of the wiring between the filter capacitor 12 and the overvoltage protection device 18 is made as short as possible, and generation of an induction voltage in the L1 and L2 parts may be suppressed.

According to the embodiment, the filter capacitor 12 and the overvoltage protection device 18 are provided closer to each other so that the conductor wiring length between the filter capacitor 12 and the overvoltage protection device 18 may be the shortest, and thereby, the inductance component of the conductor wiring between the filter capacitor 12 and the overvoltage protection device 18 is reduced to the negligible level and the snubber circuit 184A may be eliminated. Thus, the reduction in weight and size of the overvoltage protection device 18 may be realized and the improvement in reliability of the power converter 10 may be realized.

Further, for the connection between the filter capacitor 12 and the overvoltage protection device 18, the conductor bar 13 having the thin flat plate shape is extended close to and along them, and thereby, further reduction in wiring inductance may be realized.

Furthermore, with the reduction in weight of the overvoltage protection device 18, the overvoltage protection device 18 may be directly attached and fixed to the power converter 10 so that the filter capacitor 12 and the overvoltage protection device 18 may be arranged closer to each other.

### IN-HOUSE STATE OF THE ART

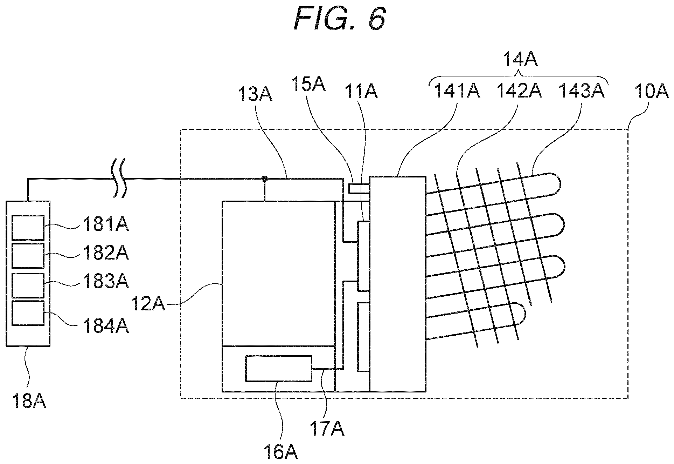

As below, a power converter 10A in related in-house state of the art will be explained with reference to Figs. 6 to 8. The same configurations as those of the power converter 10 in the embodiment have the same signs or the same signs with A and their explanation will be omitted, and the different configurations will be explained.

Fig. 6 shows a front configuration of the power converter 10A in related in-house state of the art. The power converter 10A in related in-house state of the art is different from the power converter 10 in the embodiment in the following points.

That is, the power converter 10A in related in-house state of the art is different from the power converter 10 in the embodiment in that the power converter 10A is installed separately from an overvoltage protection device 18A within the same casing 1, the length of wiring between the overvoltage protection device 18A and a filter capacitor 12A is equal to or longer than a certain length because of separate installation and an induction voltage is generated in the parts and the induction voltage may be applied to a power switching element 182A provided in the overvoltage protection device 18A, and a snubber circuit 184A is provided within the overvoltage protection device 18A for protecting the power switching element 182A.

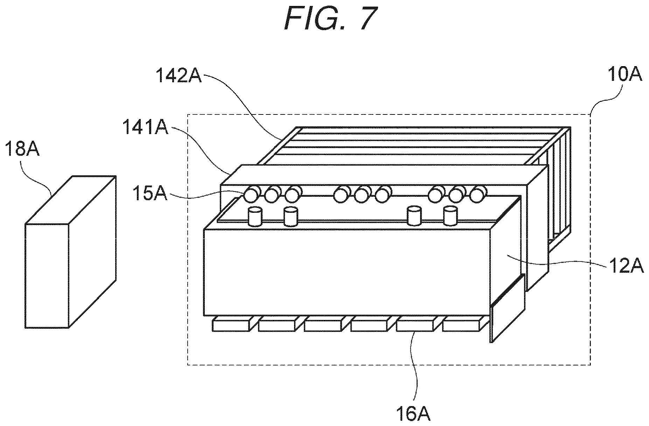

Fig. 7 shows a perspective configuration of the power converter 10A in related in-house state of the art. In the power converter 10A, the filter capacitor 12A, a cooling block 141A, and a cooling fin 142A are sequentially arranged from the front side to the depth side, and gate control circuits 16A are provided under the filter capacitor 12A, and input/output terminals 15A are provided in the cooling block 141A. These are housed within the same casing 1 as the power converter 10A. Further, the overvoltage protection device 18A is installed separately from the power converter 10A within the same casing 1.

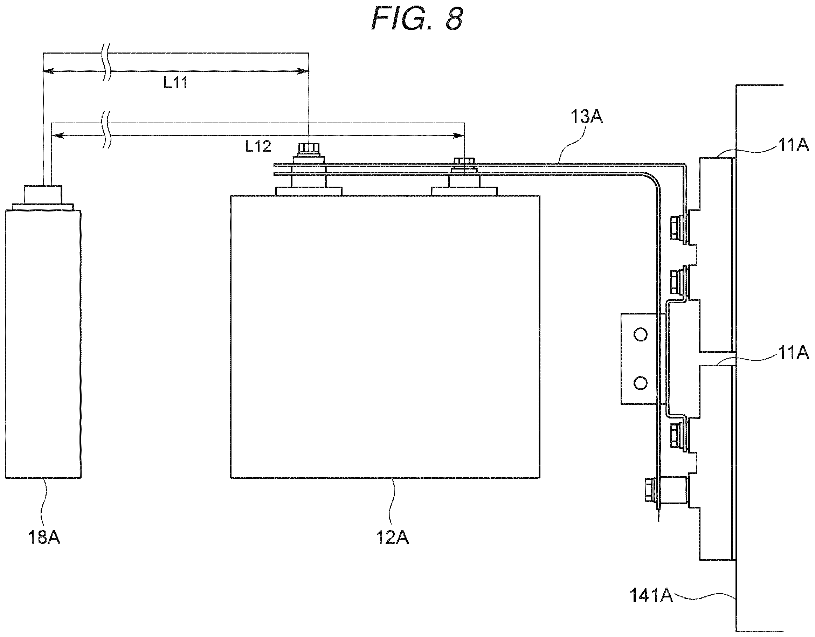

Fig. 8 shows a front configuration of a main part of the power converter 10A in related in-house state of the art. Here, of the power converter 10A shown in Fig. 6, particularly, power switching elements 11A, the filter capacitor 12A, a conductor bar 13A, the cooling block 141A, and the overvoltage protection device 18A are shown.

In the related in-house state of the art, physical distances L11 and L12 between the filter capacitor 12A and the overvoltage protection device 18A are longer and an inductance voltage is generated in the parts. Accordingly, in order to protect the power switching element 182A from the induction voltage, the snubber circuit 184A is necessary for the overvoltage protection device 18A. The snubber circuit 184A includes a snubber resistor, a snubber diode, and a snubber capacitor as described above and the snubber capacitor is particularly heavy and bulky, and thereby, hinders reduction in weight and size of the casing 1 housing the overvoltage protection device 18A.

## Claims

1. A power converter (10) for rolling stock comprising:
a filter capacitor (12) that smooths a DC voltage;
a plurality of power switching elements (11) that convert a DC voltage into an AC voltage;
a cooling unit (14) that cools the power switching elements; and
a conductor bar (13) that electrically connects the filter capacitor, the overvoltage protection device, and the power switching elements,
**characterised in that**:
the power converter further comprises an overvoltage protection device (18) that releases charge accumulated in the filter capacitor, the overvoltage protection device comprising:
a DC voltage detector (181) that detects a voltage accumulated in the filter capacitor,
a power switching element (182) for overvoltage protection device switched to ON when the charge accumulated in the filter capacitor is released, and
a drive circuit (183) that controls drive of the power switching element for overvoltage protection device;
the overvoltage protection device is provided adjacent to the filter capacitor and does not include a snubber circuit,
the overvoltage protection device, the filter capacitor and the power switching elements are sequentially arranged from one side, and
the conductor bar has a thin flat plate shape, and is placed along surfaces of the filter capacitor and the overvoltage protection device,
whereby the length of the conductor bar between the overvoltage protection device and the filter capacitor is so short that the conductor bar has a substantially zero inductance.

## Patentansprüche

1. Leistungswandler (10) für Schienenfahrzeuge, der Folgendes umfasst:
einen Filterkondensator (12), der eine Gleichspannung glättet;
eine Vielzahl von Leistungsschaltelementen (11), die eine Gleichspannung in eine Wechselspannung umwandeln;
eine Kühleinheit (14), die die Leistungsschaltelemente kühlt; und
eine Leiterschiene (13), die den Filterkondensator, die Überspannungsschutzvorrichtung und die Leistungsschaltelemente elektrisch miteinander verbindet,
**dadurch gekennzeichnet, dass**:
der Leistungswandler ferner eine Überspannungsschutzvorrichtung (18) umfasst, die Ladung freigibt, die in dem Filterkondensator akkumuliert wurde, wobei die Überspannungsschutzvorrichtung Folgendes umfasst:
einen Gleichspannungsdetektor (181), der eine Spannung detektiert, die in dem Filterkondensator akkumuliert wurde,
ein Leistungsschaltelement (182) zum Schalten der Überspannungsschutzvorrichtung auf EIN, wenn die in dem Filterkondensator akkumulierte Ladung freigegeben wird, und
eine Ansteuerschaltung (183), die die Ansteuerung des Leistungsschaltelements für die Überspannungsschutzvorrichtung steuert;
wobei die Überspannungsschutzvorrichtung benachbart zu dem Filterkondensator bereitgestellt ist und keine Snubber-Schaltung umfasst,
wobei die Überspannungsschutzvorrichtung, der Filterkondensator und die Leistungsschaltelemente von einer Seite der Reihe nach angeordnet sind, und
wobei die Leiterschiene die Form einer dünnen, flachen Platte aufweist und entlang von Oberflächen des Filterkondensators und der Überspannungsschutzvorrichtung angeordnet ist,
und wobei die Länge der Leiterschiene zwischen der Überspannungsschutzvorrichtung und dem Filterkondensator so kurz ist, dass die Leiterschiene im Wesentlichen null Induktivität aufweist.

## Revendications

1. Convertisseur de puissance (10) pour matériel roulant, comprenant :
un condensateur de filtre (12) qui lisse une tension de courant continu, CC ;
une pluralité d'éléments de commutation de puissance (11) qui convertissent une tension CC en une tension de courant alternatif, CA ;
une unité de refroidissement (14) qui refroidit les éléments de commutation de puissance ; et
une barre conductrice (13) qui connecte électriquement le condensateur de filtre, le dispositif de protection contre une surtension et les éléments de commutation de puissance,
**caractérisé en ce que** :
le convertisseur de puissance comprend en outre un dispositif (18) de protection contre une surtension qui libère une charge accumulée dans le condensateur de filtre, le dispositif de protection contre une surtension comprenant :
un détecteur de tension CC (181) qui détecte une tension accumulée dans le condensateur de filtre,
un élément de commutation de puissance (182) pour un dispositif de protection contre une surtension commuté sur MARCHE lorsque la charge accumulée dans le condensateur de filtre est libérée, et
un circuit d'entraînement (183) qui commande l'entraînement de l'élément de commutation de puissance pour un dispositif de protection contre une surtension ;
le dispositif de protection contre une surtensions est prévu adjacent au condensateur de filtre et ne comprend pas de circuit d'amortissement,
le dispositif de protection contre une surtension, le condensateur de filtre et les éléments de commutation de puissance sont agencés séquentiellement à partir d'un côté, et
la barre conductrice a une forme de plaque plate mince, et est placée le long de surfaces du condensateur de filtre et du dispositif de protection contre une surtension,
de sorte que la longueur de la barre conductrice entre le dispositif de protection contre une surtension et le condensateur de filtre est si courte que la barre conductrice a une inductance sensiblement nulle.
